# EUROPEAN PATENT SPECIFICATION

(11) **EP 4 333 068 B1**
(45) Date of publication and mention of the grant of the patent: **07.10.2026**
(21) Application number: 22794375.0
(22) Date of filing: 15.03.2022
(51) Int. Cl.: H10K 59/131, H10K 77/10, H10K 59/80, H10K 59/124, H10K 102/00, H10K 59/12

(54) **DISPLAY PANEL AND PREPARATION METHOD THEREFOR, AND ELECTRONIC DEVICE**
ANZEIGETAFEL UND HERSTELLUNGSVERFAHREN DAFÜR SOWIE ELEKTRONISCHE VORRICHTUNG
PANNEAU D'AFFICHAGE ET SON PROCÉDÉ DE PRÉPARATION, ET DISPOSITIF ÉLECTRONIQUE

(30) Priority: 29.04.2021 CN 202110473841
(43) Date of publication of application: 06.03.2024
(73) Proprietor: GUANGDONG OPPO MOBILE TELECOMMUNICATIONS CORP., LTD., Dongguan, Guangdong 523860 (CN)
(72) Inventor: GUO, Tianfu, Dongguan, Guangdong 523860 (CN)
(74) Representative: Grassi, Stefano
(86) International application number: PCT/CN2022/080957
(87) International publication number: WO 2022/227897

(56) References cited:
- WO-A1-2020/063128
- CN-A- 108 649 063
- CN-A- 109 037 279
- CN-A- 109 860 411
- CN-A- 109 994 534
- CN-A- 112 071 883
- CN-A- 113 206 136
- CN-B- 108 417 608
- US-A1- 2018 130 966

## Description

### TECHNICAL FIELD

The present disclosure relates to the field of display technologies, and in particular to a display panel and a preparation method therefor, and an electronic device.

### BACKGROUND

The statements herein merely provide background information related to the present disclosure, and do not necessarily constitute exemplary techniques.

With the development of the display technology, users have higher and higher requirements for the screen-to-body ratio of a display screen, where the higher the screen-to-body ratio, the better the display effect. The screen-to-body ratio of the display screen is defined as a ratio of the size of the display area to the size of the area enclosed by the frame in the display screen. Therefore, how to effectively reduce the size of the area occupied by the frame of the display screen is a key point to improve the screen-to-body ratio.

CN 112071883A discloses a display panel and a display device. The display panel includes a corner area, and the corner area includes a corner display area, a corner edge area and a corner wiring area located between the corner display area and the corner edge area. The corner area includes: a flexible substrate layer, having a substrate groove located in the corner wiring area and a plurality of first open holes located in the corner display area; a display function layer, which is formed on the flexible substrate layer and located in the corner display area, and provided with second open holes corresponding to the first open holes; a peripheral circuit layer which is formed on the flexible substrate layer and located in the corner wiring area. The peripheral circuit layer includes one or more peripheral wires, and the orthographic projection of at least part of the peripheral wires on the flexible substrate layer is located in the substrate groove. The corner area further includes an anti-crack barricade which is formed on the flexible substrate layer and is positioned in the corner edge area.

WO 2020063128A provides an array substrate, a display panel and a display apparatus. The array substrate includes a substrate body, the substrate body includes a display area and a non-display area, the non-display area includes a fan-out area provided with a fan-out signal line, and the fan-out signal line is connected to a signal line in the display area. The fan-out area includes an inorganic insulating layer arranged between the substrate body and a planarization layer. The inorganic insulating layer is provided with a first groove. The orthographic projection of at least part of the fan-out signal line on the substrate body is located in the orthographic projection of the first groove on the substrate body.

CN 108417608B provides a flexible display panel and a display apparatus. The flexible display panel includes a substrate; an inorganic layer located at one side of the substrate; and an organic layer located at one side, far from the substrate, of the inorganic layer. The inorganic layer includes a groove area and non-groove areas. The groove area includes a groove whose opening is arranged towards one side far from the substrate, the organic layer includes a filling portion, the projection of the filling portion in a direction vertical to the substrate is located in the groove of the groove area, and in at least one first cross section vertical to the substrate. The non-groove areas are located at two sides of the groove area. The surface, far from the side of the substrate, of the filling portion is a recessed surface. The recessed surface is recessed towards the side of the substrate.

US 20180130966A1 discloses a display device, which includes a base substrate layer including a first base substrate and a second base substrate separated from the first base substrate in a first direction, a flexible film disposed on a first surface of the base substrate layer, and one or more light emitting elements disposed on a first surface of the flexible film. The flexible film includes a flat portion and a bent portion. The bent portion is inserted into a space between the first base substrate and the second base substrate.

### SUMMARY

Embodiments of the present disclosure provide a display panel and a preparation method therefor, and an electronic device, by which the screen-to-body ratio of the display screen is improved. The invention is set out in the appended set of claims.

The details of one or more embodiments of the present application are set forth in the following drawings and descriptions. Other features, objectives and advantages of the present application will be apparent from the description, drawings, and claims.

### BRIEF DESCRIPTION OF THE DRAWINGS

In order to more clearly explain technical solutions of the embodiments of the present disclosure, drawings used in the embodiments will be briefly introduced below. Obviously, the drawings as described below are merely some embodiments of the present disclosure. Based on these drawings, other drawings can be obtained by those skilled in the art without inventive effort.
FIG. 1 is a schematic structural diagram of a display panel according to an embodiment.
FIG. 2 is a schematic cross-sectional view of the display panel of the embodiment of FIG. 1 taken along line A-A.
FIG. 3 is a schematic cross-sectional view of a display panel taken along line A-A according to an embodiment.
FIG. 4 is a schematic view illustrating a cross section of a first groove according to an embodiment.
FIG. 5 is a schematic view illustrating a cross section of a first groove according to an embodiment.
FIG. 6 is a schematic view illustrating a cross section of a first groove according to an embodiment.
FIG. 7 is a schematic view illustrating a cross section of a first groove according to an embodiment.
FIG. 8 is a schematic view illustrating a cross section of a first groove according to an embodiment.
FIG. 9 is a schematic diagram illustrating a longitudinal section of a first groove according to an embodiment.
FIG. 10 is a schematic diagram illustrating a longitudinal section of a first groove according to an embodiment.
FIG. 11 is a schematic diagram illustrating a longitudinal section of a first groove according to an embodiment.
FIG. 12 is a schematic structural diagram of a base plate illustrated in the embodiment of FIG. 3.
FIG. 13 is a schematic cross-sectional view of a display panel taken along line A-A according to the claimed invention.
FIG. 14 is a schematic view illustrating a cross section of a fourth groove according to an embodiment.
FIG. 15 is a schematic view illustrating a cross section of a fourth groove according to an embodiment.
FIG. 16 is a schematic structural diagram of a base plate illustrated in the embodiment of FIG. 13.
FIG. 17 is a schematic cross-sectional view of the display panel illustrated in FIG. 13 taken along line A-A.
FIG. 18 is a flowchart of a preparation method for a display panel according an embodiment.
FIG. 19 is a flowchart of block 102 according to an embodiment.
FIG. 20 is a flowchart of a preparation method for a display panel according to the claimed invention.
FIG. 21 is a flowchart of block 302 according to an embodiment.

### DETAILED DESCRIPTION OF PREFERRED EMBODIMENTS

For ease of understanding of the present disclosure, the present disclosure will be comprehensively described with reference to the accompanying drawings. Preferred embodiments of the present disclosure are presented in the accompanying drawings. However, the present disclosure may be implemented in many different forms and is not limited to the embodiments described herein. Rather, the purpose of providing these embodiments is to enable thorough and comprehensive understanding of the contents of the present disclosure.

It will be understood that the terms "first", "second", and the like used in the present disclosure may be used herein to describe various elements, but these elements are not limited by these terms. These terms are only used to distinguish a first element from another element, and cannot be understood as indicating or implying relative importance or implicitly indicating the number of technical features indicated. Thus, a feature defined by "first", "second" may explicitly or implicitly indicate that at least one such feature is included. In the description of the present disclosure, "a plurality of" means at least two, for example, two, three, or the like, unless otherwise specified specifically.

Unless otherwise defined, all technical and scientific terms used herein have the same meaning as commonly understood by those skilled in the art of the present disclosure. The terminology used herein in the specification of the present disclosure is for the purpose of describing specific embodiments only and is not intended to limit the present disclosure.

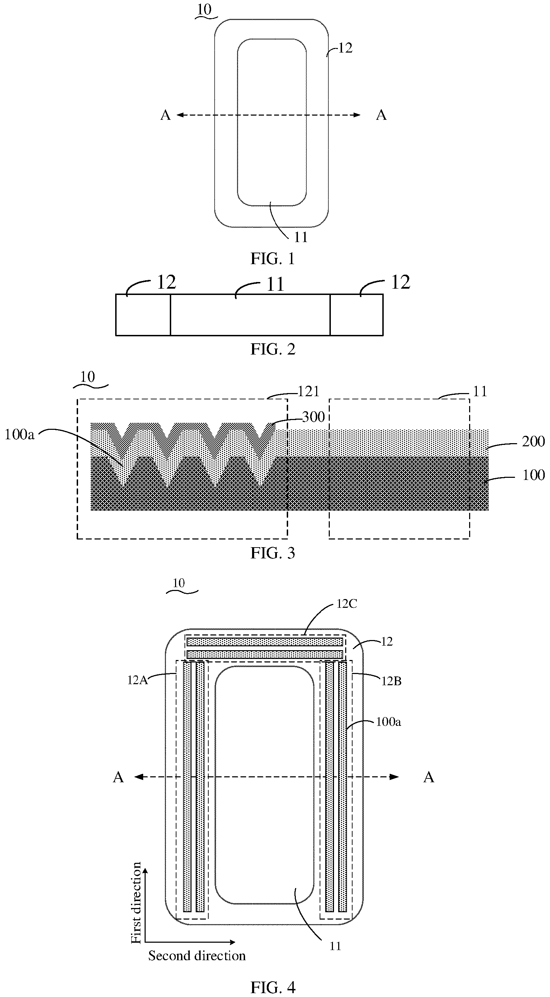

Referring to FIG. 1, FIG. 1 is a schematic structural diagram of a display panel according to an embodiment.

In the embodiment, the display panel 10 is configured to implement a display function of the electronic device, and the electronic device may be a mobile phone, a tablet computer, a notebook computer, a personal digital assistant, a television, a multimedia display panel, or the like. Specifically, FIG. 1 is a schematic structural diagram of a display panel according to an embodiment, and FIG. 2 is a schematic cross-sectional view of the display panel of the embodiment of FIG. 1 along line A-A. As illustrated in FIG. 1 and FIG. 2, the display panel 10 is divided into a display area 11 and a non-display area 12, and the non-display area 12 is provided around an edge of the display area 11. The display area 11 is configured to implement the display function, and the non-display area 12 is configured for provision of wirings, circuit structures and other laminated structures.

FIG. 3 is a schematic structural diagram of a display panel according to an embodiment. The display panel 10 includes a base plate 100, an interlayer insulating layer 200, and a wiring 300.

In the embodiment, the base plate 100 is configured to provide a first groove therein, and support the interlayer insulating layer 200, the wiring 300 and other laminated structures (not illustrated). The overall thickness of the base plate 100 may be 15 µm to 50 µm, so that there is a large space for providing a groove in the base plate, and a deep groove may be obtained. The process of providing a groove in the base plate 100 is simple, which is beneficial to improving the yield.

The base plate 100 is provided with a plurality of first grooves 100a, and the plurality of first grooves 100a are located in the non-display area 12. The first grooves 100a are configured to receive the interlayer insulating layer 200 at respective positions, so that second grooves 200a are provided at positions corresponding to the first grooves 100a. The second grooves 200a have the same concave forms as the first grooves 100a, so that the second grooves 200a have the same shape and size as the first grooves 100a. By means of the provision of the first grooves 100a, the area of the exposed portion of the base plate 100 in the non-display area 12 may be increased, which increases the effective contact area between the interlayer insulating layer 200 and the base plate 100; in addition, the plurality of the second grooves 200a having the same concave forms as the first grooves 100a are obtained for the filling of the wiring 300, which increases the effective contact area between the wiring 300 and the interlayer insulating layer 200, and reduces the occupied area in the horizontal plane of the non-display area 12 that is occupied by the wiring 300, so that the non-display area 12 can be narrowed. In some embodiments, the number of the first grooves 100a is not less than 2, so that the effective contact area between the interlayer insulating layer 200 and the base plate 100 may be greatly increased.

In the embodiment, the base plate 100 is provided with a plurality of wiring areas 121.
The first grooves 100a are located in at least one wiring area 121, so that the first grooves 100a enable the area of the exposed portion of the at least one wiring area 121 on the base plate 100 to be increased, which increases the effective contact area between the interlayer insulation layer 200 and the base plate 100. When the first grooves 100a are located in the plurality of wiring areas 121, the first grooves 100a enable the area of the exposed portions of the plurality of wiring areas 121 on the base plate 100 to be increased, thereby further increasing the effective contact area between the interlayer insulation layer 200 and the base plate 100.

In some embodiments, there are a plurality of first grooves 100a. In each wiring area 121, at least two first grooves 100a are arranged along a first direction and/or at least two first grooves 100a are arranged along a second direction. The first direction and the second direction intersect with each other, and an included angle between the first direction and the second direction is greater than 0 degree and less than 180 degrees. The first direction and the second direction are not limited, and the first direction and the second direction may be adjusted according to actual requirements of the wiring 300 or processing conditions.

When at least two first grooves 100a are arranged along the first direction or at least two first grooves 100a are arranged along the second direction, the plurality of first grooves 100a define a plurality of groove structures interruptedly distributed in the same arrangement direction, so as to achieve the purpose of narrowing the wiring area 121. The provision of the plurality of groove structures in the same direction may simplify the processing steps, which is beneficial to large-scale production of the product.

When at least two first grooves 100a are arranged along the first direction and at least two first grooves 100a are arranged along the second direction, the plurality of first grooves 100a define, along each of multiple arrangement directions, a plurality of groove structures interruptedly distributed. This can improve the distribution density of the first grooves 100a, and improve the bonding strength between the interlayer insulating layer 200 and the base plate 100 as well as the bonding strength between the wiring 300 and the interlayer insulating layer 200. Further, the plurality of first grooves 100a are arranged in an array along each of the first direction and the second direction, and thus a plurality of groove structures are defined by arranging the plurality of first grooves 100a in an array along each of the multiple directions, this further improves the distribution density of the groove structures. It may be understood that, in an area where the array is arranged, every two adjacent first grooves 100a may be arranged side-by-side and aligned, or may be arranged to be staggered with each other, depending on the cross-sectional shape and the distribution density of the first grooves 100a.

In some embodiments, the non-display area 12 includes a first area 12A and a second area 12B that are provided on two opposite sides of the display area 11. The non-display area 12 further includes a third area 12C connecting the first area 12A with the second area 12B. The first direction is perpendicular to an alternating direction along which the first area 12A, the display area 11, and the second area 12B take place by turn. In each of the wiring areas 121 of the first area 12A and the second area 12B, the at least one first groove 100a extends along the first direction. In the wiring area of the third area 12C, the at least one first groove extends along the alternating direction. The first groove(s) 100a extending along the first direction in each of the first area 12A and the second area 12B may greatly increase the area of the exposed portion in the extending direction, and may effectively reduce the area occupied by the first groove(s) 100a in the alternating direction, thereby further effectively improving the screen-to-body ratio. The first groove(s) 100a extending along the alternating direction in the third area 12C may greatly increase the area of the exposed portion in the extending direction, and effectively reduce the area occupied by the first groove(s) 100a in the first direction, thereby effectively improving the screen-to-body ratio. When the arrangement direction of the plurality of first grooves 100a is the same as the extension direction of the first grooves 100a, the number of the first grooves arranged along the arrangement direction is further reduced, thereby further simplifying the processing, and facilitating the large scale production of the product.

In some embodiments, the plurality of wiring areas 121 surround the edge of the display area 11, and each wiring area 121 is provided with at least one first groove 100a; in this way, it is ensured that the wiring area 121 located at each edge side of the display area 11 may be reduced. It may be understood that, the plurality of wiring areas 121 may surround the three edge sides of the display area 11, for example, they surround the upper edge side, the left edge side and the right edge side of the display area 11, or may surround the four edge sides of the display area 11, where the specific surrounding mode may be set based on the actual distribution area of the wiring 300.

In some embodiments, the plurality of wiring areas 121 are symmetrically distributed with respect to an axis of symmetry, and the first grooves 100a are symmetrically arranged with respect to the axis of symmetry or the plurality of first grooves 100a are symmetrically distributed with respect to the axis of symmetry, so that the size of the non-display area 12 may be reduced symmetrically, and the display effect of the display screen is improved.

In some embodiments, the first groove 100a is a strip-type groove, an annular groove, or a hole-type groove. Each of the strip-type groove and the annular groove has high continuity in extension along the length direction thereof, which enables high area utilization in the extension direction, and facilitates the provision of a deep groove. The hole-type groove has low continuity in extension along the length direction thereof, which facilitates the selection of various arrangement modes, and the distribution density may be effectively increased. When the first grooves 100a are only located in one wiring area 121, the first grooves 100a may be the strip-type groove, the annular groove, or the hole-type groove. When the first grooves 100a are located in the plurality of the wiring areas 121, the first grooves 100a may be the strip-type groove or the annular groove.

In some embodiments, the strip-type groove may be a linear strip-type groove, or a curved strip-type groove (for example, a strip-type groove in "S" shape), a polyline-like strip-type groove (for example, a polyline-like groove in "Z" shape) or a tree-like strip-type groove (for example, a groove in shape of a Chinese character " 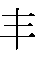 ").

Taking a case where the first direction is perpendicular to the alternating direction along which the first region 12A, the display area 11 and the second region 12B take place by turn and the second direction is parallel to the alternating direction along which the first region 12A, the display area 11 and the second region 12B take place by turn as an example, as illustrated in FIG. 4, the first groove 100a is a strip-type groove, and a plurality of continuously extending strip-type grooves are provided in the wiring area 121, so as to achieve the purpose of narrowing the wiring area 121 by providing a small number of strip-type grooves.

In some embodiments, the annular groove includes a closed annular groove or an open annular groove. The closed annular groove may be a circular groove, or may be an annular groove in any polygonal shape, for example, a rectangular ring-like groove. The open annular groove may be an open circular groove, or may be an open annular groove in any polygonal shape, for example, an open annular groove in a hexagonal shape, octagonal shape, dodecagonal shape, or other polygonal shapes. When an annular groove is located in multiple wiring areas, the annular groove is provided around the display area 11.

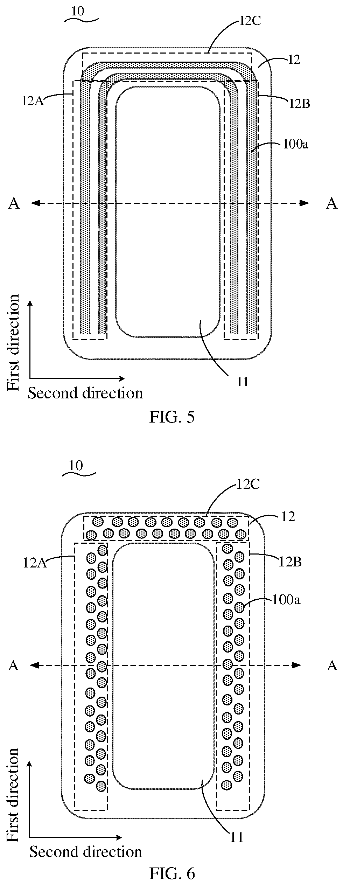

Taking the case where the first direction is perpendicular to the alternating direction along which the first region 12A, the display area 11 and the second region 12B take place by turn and the second direction is parallel to the alternating direction along which the first region 12A, the display area 11 and the second region 12B take place by turn as an example, as illustrated in FIG. 5, the first grooves 100a each are an annular groove provided around the display area 11, each first groove 100a is located in the plurality of wiring areas 121, the plurality of first grooves 100a define a plurality of continuous annular grooves, so as to achieve the purpose of narrowing the wiring area 121 by providing a small number of annular grooves.

In some embodiments, the cross section of the hole-type groove is in a circular shape, a quasi-circular shape or a polygonal shape, where the number of sides of the polygon is not less than three, and the cross section is a section parallel to the length direction of the first groove 100a. A quasi-circular shape includes an ellipse shape and a pattern formed by at least two arcs, such as a shape of "8" consisting of two semi-arcs.

Taking a case where the first direction is perpendicular to the alternating direction along which the first region 12A, the display area 11 and the second region 12B take place by turn and the second direction is parallel to the alternating directions along which the first region 12A, the display area 11 and the second region 12B take place by turn as an example: for example, as illustrated in FIG. 6, the cross section of the first groove 100a is in a circular shape, any two circular grooves adjacent in the first direction are arranged side by side and aligned, and any two circular grooves adjacent in the second direction are staggered with each other, so that the plurality of circular grooves are distributed densely, and the area of the exposed portion of the groove structure is further increased, thereby reducing the area of the wiring area 121.

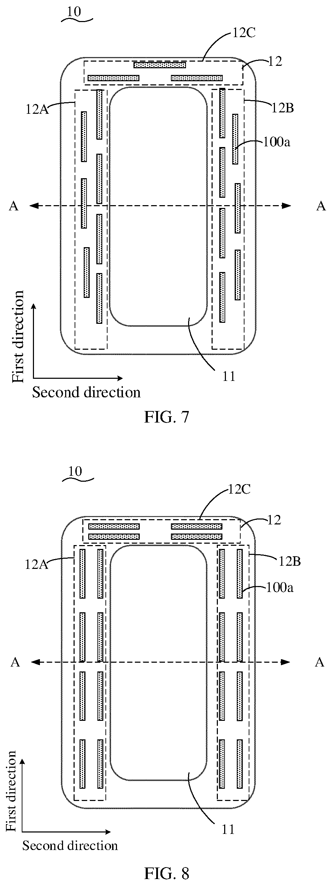

For example, as illustrated in FIG. 7, the cross section of the first groove 100a is in a rectangular shape, any two rectangular grooves adjacent in the first direction are arranged side by side and aligned, and any two rectangular grooves adjacent in the second direction are staggered with each other, so that the plurality of rectangular grooves are distributed densely, the area of the exposed portion of the groove structure is further increased, thereby further reducing the size of the wiring area 121.

For example, as illustrated in FIG. 8, the cross section of the first groove 100a is in a rectangular shape, any two rectangular grooves adjacent in the first direction are arranged side by side and aligned, and any two rectangular grooves adjacent in the second direction are arranged side by side and aligned, so that the plurality of rectangular grooves are distributed densely, the area of the exposed portion of the groove structure is further increased, thereby further reducing the area of the wiring area 121.

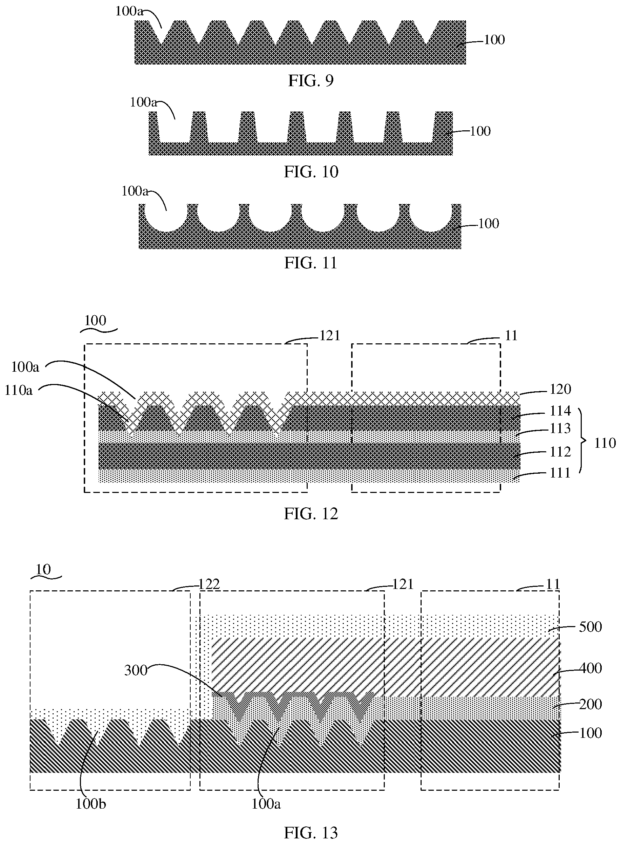

In some embodiments, the longitudinal section of the first groove 100a is in an open-top shape with an opening increasing gradually from a side facing away from the wiring 300 to a side close to the wiring 300, where the longitudinal section is a section perpendicular to the length direction of the first groove 100a. Therefore, the interlayer insulating layer 200 may be uniformly deposited and distributed on the exposed surface of the first grooves 100a to obtain the second grooves 200a, and then the wiring 300 may be uniformly deposited and distributed on the exposed surface of the second grooves 200a. The longitudinal section of the first groove 100a may be, but not limited to, in a triangle shape (as illustrated in FIG. 9), an inverted trapezoid shape (as illustrated in FIG. 10), a semicircle shape (as illustrated in FIG. 11) or a semi-ellipse shape. In other embodiments, the longitudinal section of the first groove 100a may also be in an open-top shape with an opening of substantially the same size in the depth direction, for example, the longitudinal section of the first groove 100a may be in a "U" shape.

In some embodiments, a width of the first groove 100a is greater than 3 µm, and a depth of the first groove 100a is greater than 3 µm, so that the first groove 100a has a large exposed area. It is easy to understand that, the depth of the first groove 100a is the dimension of the first groove 100a in a direction perpendicular to the base plate 100. Further, a spacing between two adjacent first grooves 100a is not less than 10 µm, which is beneficial to provide a complete first groove 100a, and improve the yield of the product. It may be understood that, two adjacent first grooves 100a may be provided to be spaced from each other, or may be continuously provided. Considering the manufacturing process, adjacent first grooves 100a may be mainly provided to be spaced from each other, so that there is small stress at the surface of the base plate 100, and the reliability is high.

In some embodiments, as illustrated in FIG. 12, the base plate 100 includes a flexible substrate 110 and an inorganic base layer 120.

The flexible substrate 110 is provided with a plurality of third grooves 110a, where the plurality of third grooves 110a are located in the non-display area 12. Positions of the third grooves 110a correspond to the positions of the first grooves 100a respectively, and the third grooves 110a are configured to receive the inorganic base layer 120 at the corresponding positions, so that the first grooves 100a with the matching shape and size are defined. For details of the shape, size and distribution of the third grooves 110a, reference may be made to the related description of the first grooves 100a in the above embodiments, which are not repeated herein.

Exemplarily, in the embodiments, the flexible substrate 110 includes a support plate 111, and includes a first organic base layer 112, a barrier layer 113, and a second organic base layer 114 that are sequentially provided on the support plate 111. The third grooves 110a are provided in the second organic base layer 114. The support plate 111 may be a glass support plate. The first organic base layer 112 and the second organic base layer 114 may be made of a same material, for example, each of them may be made of polyimide (PI), so as to effectively improve the transmittance. The barrier layer 113 may be made of a material capable of blocking water and oxygen, for example a material of SiN, SiO, SiC, and Al2O3. A thickness of the first organic base layer 112 may be 10 µm to 20 µm, a thickness of the barrier layer 113 may be 0.05 µm to 0.1 µm, and a thickness of the second organic base layer 114 may be 6 µm to 15 µm.

The inorganic base layer 120 is provided on the flexible substrate 110, and the inorganic base layer 120 is provided with the plurality of first grooves 100a at positions corresponding to the third grooves 110a, and the shape and size of the first grooves 100a match the shape and size of the third grooves 110a. The inorganic base layer 120 may be a SiO, SiN, or a-Si inorganic layer or other inorganic layer. The inorganic base layer 120 may have a thickness of 1 µm to 5 µm.

Grooves are provided in the flexible substrate 110, and it is beneficial to simplify the process of providing such grooves as the flexible substrate 110 has high flexibility. Moreover, the thickness of the flexible substrate 110 is 15 µm to 50 µm, and deep third grooves 110a may be provided in the flexible substrate 110 so as to increase the area of the exposed portion of the flexible substrate 110. The inorganic base layer 120 is formed on the flexible substrate 110 on which the grooves haven been provided. Since the inorganic base layer 120 is generally a film deposited on a whole surface, it is beneficial to obtain a uniform thickness of the film, and the first grooves 100a with a smooth exposed surface and uniform thickness are obtained. Since the inorganic base layer 120 has high rigidity, it is beneficial to stabilize the shape of the first grooves 100a.

In the embodiments, the interlayer insulating layer 200 is provided on the base plate 100 and covers the first grooves 100a, and the interlayer insulating layer 200 is provided with a plurality of second grooves 200a at positions corresponding to the first grooves 100a. For details of the shape, size and distribution of the second grooves 200a, reference may be made to the related description of the first grooves 100a in the above embodiments, which are not repeated herein. The material of the interlayer insulating layer 200 includes SiNx and SiOx, so that the second grooves 200a have high density and flatness.

The thickness of the interlayer insulating layer 200 is generally 0.25 µm to 0.50 µm, for example, 0.3 µm, and the thickness of the base plate 100 is generally 15 µm to 50 µm, which is much greater than the thickness of the interlayer insulating layer 200. Therefore, the depths of the first grooves 100a and the second grooves 100b may be much greater than the thickness of the interlayer insulating layer 200 located in the display area 11. Compared with a case where grooves are directly provided in the interlayer insulating layer 200 for increase of the area of the exposed portion, the second grooves 100b of the embodiments enable the area of the exposed portion of the interlayer insulating layer 200 to be increased, so that the size of the non-display area 12 can be effectively reduced to improve the screen-to-body ratio.

In the embodiments, the wiring 300 is provided in the wiring area 121 of the interlayer insulating layer 200, and fills the second grooves 200a.

The wiring 300 is a cathode wiring, the cathode wiring is a cathode voltage input terminal of the display panel. The wiring 300 is provided around the display area 11, and is electrically connected with a driving chip to receive a low voltage VSS from the driving chip and transmit the voltage to the cathode, so as to drive the light-emitting device in the display area 11 to emit light. Exemplarily, there are four non-display areas 12 respectively located at the four edge sides of the display area 11, and the wiring 300 is provided in three non-display areas 12 respectively located at three edge sides of the display area 11, for example, it is provided on the non-display areas 12 located at the upper edge side, the left edge side and the right edge side of the display area 11. The driving chip is provided in the non-display area 12 located at the lower edge side of the display area 11. The wiring 300 may be made of a metal material, and the wiring 300 may be a single metal layer or a metal stack layer such as a Ti/Al/Ti metal stack layer.

It may be understood that, if the occupied area of the wiring area 121 that is occupied by the wiring 300 is too small, the resistance of the cathode wiring is increased, which would cause an optical problem of uneven display brightness of the display screen. In order to ensure that the display screen can normally display an image, it is usually required that the wiring area 121 has a width ranging from 200 µm to 220 µm. In the embodiments, by means of the second grooves 200a, the effective contact area between the wiring 300 and the interlayer insulation layer 200 can be increased, the surface resistance of the wiring area 121 can be reduced. On this basis, the size of the wiring area 121 may be reduced, thereby reducing the area occupied by the cathode wiring 300 on the display screen, and then effectively enlarging the area actually used for display, and achieving the purpose of reducing the frame of the display screen. The width of the wiring 300 is expected to be reduced to be in a range between 100 µm and 150 µm.

The display panel provided in the embodiments includes the base plate 100, the interlayer insulating layer 200 and the wiring 300. The base plate 100 is provided with a plurality of first grooves 100a in the non-display area 12. The interlayer insulating layer 200 is provided on the base plate 100 and covers the first grooves 100a, and the interlayer insulating layer 200 is provided with a plurality of second grooves 200a at positions corresponding to the first grooves 100a. The wiring 300 is provided in the wiring area 121 of the interlayer insulating layer 200 and fills the second grooves 200a. By means of the first grooves 100a and the second grooves 200a, the effective contact area between the wiring 300 and the interlayer insulation layer 200 can be increased, the surface resistance of the wiring area 121 can be reduced; on this basis, the size of the wiring area 121 can be reduced, thus reducing the area occupied by the wiring 300 on the display screen, and effectively enlarging the area actually used for display. Therefore, the purpose of reducing the frame of the display screen is achieved, and the display effect is improved.

It may be noted that, in the embodiments, the display panel is not limited to the above laminated structure, and various layers may be added with a material with special functions based on different requirements. For example, other functional materials are added to a film of a single function to obtain a film of multiple functions.

FIG. 13 is a schematic structural diagram of a display panel according to the claimed invention. The display panel 10 includes a base plate 100, an interlayer insulating layer 200, and a wiring 300, and it further includes a light-emitting array structure 400 and an encapsulation structure 500.

The display panel 10 includes a display area 11 and a non-display area 12. The non-display area 12 includes a wiring area 121 and the encapsulation area 122, and the encapsulation area 122 is located on a side of the wiring area 121 away from the display area 11. For the description of the base plate 100, the interlayer insulating layer 200, the wiring 300 and the first grooves 100a, reference may be made to the related description in the above embodiments, which are not repeated herein.

In the claimed invention, the base plate 100 is further provided with a plurality of fourth grooves 100b, where the plurality of fourth grooves 100b are located in the encapsulation area 122. The fourth grooves 100b are configured to receive the encapsulation structure 500 at the corresponding position. The provision of the fourth grooves 100b may enable the area of the exposed portion of the encapsulation area 122 on the base plate 100 to be increased, and thus the effective contact area between the encapsulation structure 500 and the base plate 100 is increased; as such, the encapsulation structure 500 can effectively prevent the internal structure of the display panel from being eroded by water and oxygen, which effectively improves the service life of the display panel; meanwhile, it enables the occupied area in the horizontal plane of the non-display area 12 that is occupied by the encapsulation area 122 to be reduced, so as to narrow the non-display area 12. In some embodiments, the number of the fourth grooves 100b is not less than 2, so that the effective contact area between the encapsulation structure 500 and the base plate 100 can be greatly increased.

In some embodiments, the base plate 100 is provided with a plurality of encapsulation areas 122. The fourth grooves 100b are located in at least one encapsulation area 122, so that the fourth grooves 100b enable the area of the exposed portion of the at least one encapsulation area 122 on the base plate 100 to be increased, so as to increase the effective contact area between the encapsulation structure 500 and the base plate 100. When the fourth grooves 100b are located in the plurality of encapsulation areas 122, the fourth grooves 100b enable the area of the exposed portions of the plurality of encapsulation area 122 on the base plate 100 to be increased, thereby further increasing the effective contact area between the encapsulation structure 500 and the base plate 100

In the claimed invention, there are a plurality of fourth grooves 100b. In each encapsulation area 122, at least two fourth grooves 100b are arranged along a third direction and/or at least two fourth grooves 100b are arranged along a fourth direction. The third direction and the fourth direction intersect with each other, and an included angle between the first direction and the second direction is greater than 0 degree and less than 180 degrees.

When at least two fourth grooves 100b are arranged along the third direction or at least two fourth grooves 100b are arranged along the fourth direction, the plurality of fourth grooves 100b define a plurality of groove structures interruptedly distributed in the same arrangement direction, so as to achieve the purpose of narrowing the encapsulation area 122. The provision of the plurality of groove structures in the same direction may simplify the processing steps, which is beneficial to large-scale production of the product.

When at least two fourth grooves 100b are arranged along the third direction and at least two fourth grooves 100b are arranged along the fourth direction, the plurality of fourth grooves 100b define, in each of multiple arrangement directions, a plurality of groove structures interruptedly distributed. This can improve the distribution density of the fourth grooves 100b, and improve the bonding strength between the encapsulation structure 500 and the base plate 100. Further, the plurality of fourth grooves 100b are arranged in an array along each of the third direction and the fourth direction, and thus a plurality of groove structures are defined by arranging the plurality of fourth grooves 100b in an array along each of the multiple directions, this further improves the distribution density of the groove structures. It may be understood that, in the area where the array is arranged, every two adjacent fourth grooves 100b may be arranged side-by-side and aligned, or may be arranged to be staggered with each other, depending on the cross-sectional shape and distribution density of the fourth grooves 100b.

In some embodiments, the non-display area 12 includes a first area 12A and a second area 12B that are provided on two opposite sides of the display area 11. The non-display area 12 further includes a third area 12C connecting the first area 12A and the second area 12B. The third direction is perpendicular to an alternating direction along which the first area 12A, the display area 11, and the second area 12B take place by turn. In each of the encapsulation areas 122 of the first area 12A and the second area 12B, at least one fourth groove 100b extends along the third direction. In the encapsulation area of the third area 12C, at least one fourth groove 100b extends along the alternating direction. The fourth groove(s) 100b extending along the third direction in the first area 12A and the second area 12B may greatly increase the area of the exposed portion in the extending direction, and may effectively reduce the area occupied by the fourth groove(s) 100b in the alternating direction, thereby further effectively improving the screen-to-body ratio. The fourth groove(s) 100b extending along the alternating direction in the third area 12C may greatly increase the area of the exposed portion in the extending direction, and effectively reduce the area occupied by the first grooves 100a in the third direction, thereby effectively improving the screen-to-body ratio. When the arrangement direction of the plurality of fourth grooves 100b is the same as the extension direction of the fourth grooves 100b, the number of the first grooves arranged along the arrangement direction is further reduced, thereby further simplifying the processing, and facilitating the large scale production of the product.

In some embodiments, the plurality of encapsulation areas 122 surround the edge of the display area 11, and each encapsulation area 122 is provided with at least one fourth groove 100b; in this way, it is ensured that the encapsulation area 122 located at each edge side of the display area 11 may be narrowed.

In some embodiments, the plurality of encapsulation areas 122 are symmetrically distributed with respect to an axis of symmetry, the fourth grooves 100b are symmetrically arranged with respect to the axis of symmetry or the plurality of fourth grooves 100b are symmetrically distributed with respect to the axis of symmetry, so that the size of the non-display area 12 may be reduced symmetrically, and the display effect of the display screen is improved.

In some embodiments, the fourth groove 100b are a strip-type groove, an annular groove, or a hole-type groove. Each of the strip-type groove and the annular groove has high continuity in extension along the length direction thereof, which enables high area utilization in the extension direction, and facilitates the provision of a deep groove. The hole-type groove has low continuity in extension along the length direction thereof, which facilitates the selection of various arrangement modes, and the distribution density may be effectively increased. When the fourth grooves 100b are only located in one encapsulation area 122, the fourth grooves 100b may be the strip-type groove, the annular groove, or the hole-type groove. When the fourth grooves 100b are located in the plurality of the encapsulation areas 122, the fourth grooves 100b may be the strip-type groove or the annular groove.

In some embodiments, the strip-type groove may be a linear strip-type groove, or a curved strip-type groove (for example, a strip-type groove in "S" shape), a polyline-like strip-type groove (for example, a polyline-like groove in "Z" shape) or a tree-like strip-type groove (for example, a groove in shape of a Chinese character "$").

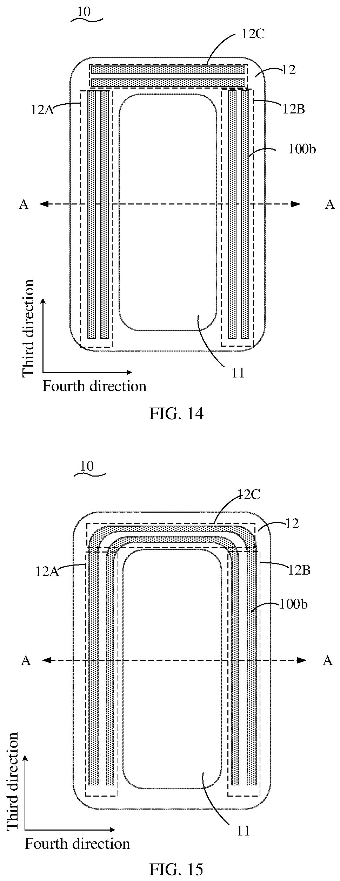

Taking a case where the third direction perpendicular to the alternating direction along which the first region 12A, the display area 11 and the second region 12B take place by turn and the fourth direction is parallel to the alternating direction along which the first region 12A, the display area 11 and the second region 12B take place by turn as an example, as illustrated in FIG. 14 (in which the wiring area is not illustrated), the fourth groove 100b is a strip-type groove, and a plurality of continuously extending strip-type grooves are provided in the encapsulation area 122, so as to achieve the purpose of narrowing the encapsulation area 122 by providing a small number of strip-type grooves.

In some embodiments, the annular groove includes a closed annular groove or an open annular groove. The closed annular groove may be a circular groove, or may be an annular groove in any polygonal shape, for example, a rectangular ring-like groove. The open annular groove may be an open circular groove, or may be an open annular groove in any polygonal shape, for example, an open annular groove in a hexagonal shape, octagonal shape, dodecagonal shape, or other polygonal shapes. When an annular groove is located in multiple wiring areas, the annular groove is provided around the display area 11.

Taking a case where the third direction perpendicular to the alternating direction along which the first region 12A, the display area 11 and the second region 12B take place by turn and the fourth direction is parallel to the alternating direction along which the first region 12A, the display area 11 and the second region 12B take place by turn as an example, as illustrated in FIG. 15 (in which the wiring area is not illustrated), the fourth grooves 100b each are an annular groove provided around the display area 11, each fourth groove 100b is located in the plurality of encapsulation areas 122, the plurality of fourth grooves 100b define a plurality of continuous annular grooves, so as to achieve the purpose of narrowing the encapsulation area 122 by providing a small number of annular grooves.

In some embodiments, the cross section of the hole-type groove is in a circular shape, a quasi-circular shape or a polygonal shape, where the number of sides of the polygon is not less than three, and the cross section is a section parallel to the length direction of the fourth groove 100b. A quasi-circular shape includes an ellipse shape and a pattern formed by at least two arcs, such as a shape of "8" consisting of two semi-arcs.

In some embodiments, the longitudinal section of the fourth groove 100b is in an open-top shape with an opening increasing gradually from a side facing away from the wiring 300 to a side close to the wiring 300, and the longitudinal section is a section perpendicular to the length direction of the fourth groove 100b. Therefore, the encapsulation structure 500 may be uniformly deposited and distributed on the exposed surface of the fourth grooves 100b. The longitudinal section of the fourth groove 100b may be, but not limited to, a triangle shape, an inverted trapezoid shape, a semicircle shape or a semi-ellipse shape. In other embodiments, the longitudinal section of the fourth groove 100b may also be in an open-top shape with an opening of substantially the same size in the depth direction, for example, the longitudinal section of the fourth grooves 100b may be in a "U" shape.

In some embodiments, a width of the fourth groove 100b is greater than 3 µm, and a depth of the fourth groove 100b is greater than 3 µm, so that the fourth groove 100b has a large exposed area. It is easy to understand that, the depth of the fourth groove 100b is the dimension of the fourth groove 100b in a direction perpendicular to the base plate 100. Further, a distance between two adjacent fourth grooves 100b is not less than 10 µm, which is beneficial to provide a complete fourth groove 100b, and improve the yield of the product. It may be understood that, two adjacent fourth grooves 100b may be provided to be spaced from each other, or may be continuously provided. Considering the manufacturing process, adjacent fourth grooves 100b may be mainly provided to be spaced from each other, so that there is small stress at the surface of the base plate 100, and the reliability is high.

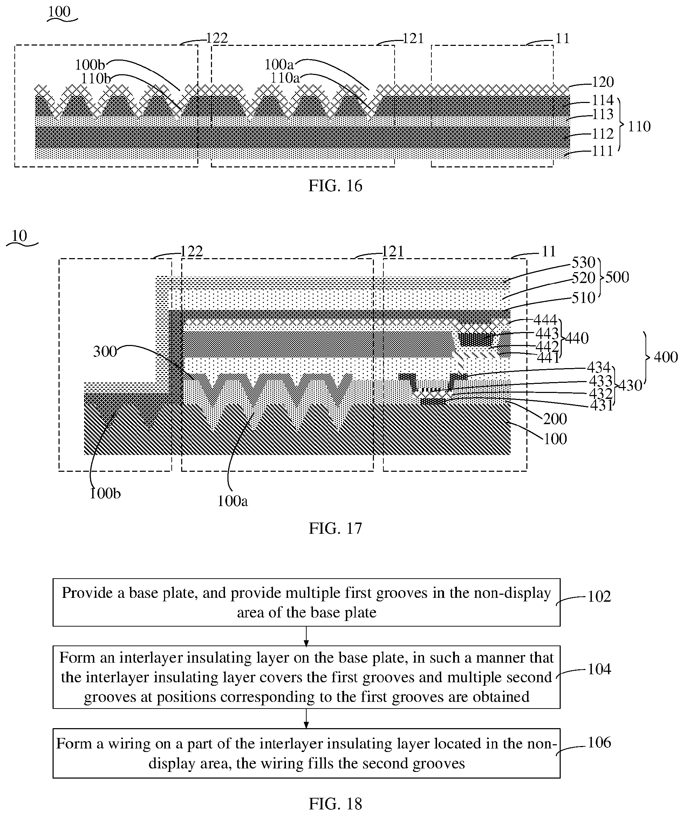

In some embodiments, as illustrated in FIG. 16, the base plate 100 includes a flexible substrate 110 and an inorganic base layer 120.

The flexible substrate 110 is provided with a plurality of third grooves 110a and a plurality of fifth grooves 110b, where the plurality of third grooves 110a are located in the wiring area 121. Positions of the third grooves 110a correspond to the positions of the first grooves 100a respectively, and the third grooves 110a are configured to receive the inorganic base layer 120 at corresponding positions, so that the first grooves 100a with the matching shape and size are defined. Positions of the fifth grooves 110b correspond to positions of the fourth grooves 100b respectively, and the fifth grooves 110b are configured to receive the inorganic base layer 120 at the corresponding positions, so that the fourth grooves 100b with the matching shape and size are defined. Exemplarily, in the embodiment, the flexible substrate 110 includes a support plate 111, and includes a first organic base layer 112, a barrier layer 113, and a second organic base layer 114 that are sequentially provided on the support plate 111. The third grooves 110a and the fifth grooves 110b are provided in the second organic base layer 114. For details of the shape, size and distribution of the third grooves 110a, reference may be made to the related description of the above embodiments. For the first organic base layer 112, the barrier layer 113, the second organic base layer 114, and the inorganic base layer 120, reference may be made to the related description of the above embodiments, and details thereof are not repeated herein. For details of the shape, size and distribution of the fifth grooves 110b, reference may be made to the related description of the fourth grooves 100b in the foregoing embodiment, which are not repeated herein.

The third grooves 110a and the fifth grooves 110b are provided in the flexible substrate 110, and it is beneficial to simplify the process of providing such grooves as the flexible substrate 110 has a high flexibility. Moreover, the thickness of the flexible substrate 110 is generally 15 µm to 50 µm, and deep grooves may be provided in the flexible substrate 110 so as to increase the area of the exposed portion of the flexible substrate 110. The inorganic base layer 120 is formed on the flexible substrate 110 on which the grooves haven been provided. Since the inorganic base layer is generally a film deposited on a whole surface, it is beneficial to obtain a uniform thickness of the film, and the first grooves 100a and the fourth grooves 100b with a smooth exposed surface and uniform thickness are obtained. Since the inorganic base layer 120 has high rigidity, it is beneficial to stabilize the shape of the first grooves 100a and the fourth grooves 100b.

In the claimed invention, the light-emitting array structure 400 is provided on the interlayer insulating layer 200 and the wiring 300, and the light-emitting array structure 400 is partially embedded in the interlayer insulating layer 200. The light-emitting array structure 400 is configured to implement a display function in the display area 11.

Exemplarily, as illustrated in FIG. 17, the light-emitting array structure 400 includes a planarization layer 410, a pixel defining layer 420, a driving unit 430, and a light-emitting unit 440.

The planarization layer 410 is provided on the interlayer insulating layer 200 and the wiring 300, and is configured to compensate the unevenness caused by the driving unit 430, the wiring 300 and the like. The planarization layer 410 is made of a conventional material, which is not limited herein. It is notable that the planarization layer 410 is generally made of an organic material. In the preparation process of the planarization layer 410, a dam is usually provided between the wiring area(s) 121 of the planarization layer 410 and the display area 11, so as to prevent the organic material from overflowing during inkjet printing. The provision of the dam causes the width of the non-display area 12 to be increased, which is not conducive to achieving a narrow frame. In the present embodiments, due to the groove structures of the wiring 300, the wiring 300 itself provides a blocking function, which enables the dam to be omitted so as to shorten the edge of the planarization layer 410, and thus further narrow the frame.

The pixel defining layer 420 is provided on the planarization layer 410, and is configured to confine the light-emitting unit 440 within a sub-pixel region defined by the pixel defining layer 420, thereby achieving high resolution and full color display. Generally, a groove structure is provided in the pixel defining layer 420 to serve as a pixel dent, and each pixel dent corresponds to one sub-pixel region. The pixel defining layer 420 is made of a conventional material, which is not limited herein.

The driving unit 430 is provided in the insulating layer and the planarization layer 410 to drive the light-emitting unit 440 to emit light. In some embodiments, the driving unit 430 is provided in the display area 11 and is close to the wiring area 121, so as to shorten the length of the signal wiring 300, and improve the reliability of signal transmission; in addition, the occupied area of the non-display area 12 that is occupied by the wiring 300 is further reduced, so as to further improve the screen-to-body ratio.

The light-emitting unit 440 is provided at the pixel defining layer 420, and penetrates through the pixel defining layer 420 and a part of the planarization layer 410. The light-emitting unit 440 is electrically connected with the driving unit 430, and the light-emitting unit 440 and the driving unit 430 are both located in the display area 11. Each sub-pixel region of the pixel defining layer 420 is provided with one or more light-emitting units 440. For example, in the embodiments, each sub-pixel region includes three light-emitting units 440 with different colors, which are red, green and blue, respectively; as such, when the driving unit 430 applies an appropriate voltage, the light-emitting units 440 generate light in three primary colors of red, green and blue (RGB).

In some embodiments, the light-emitting units 440 are in one-to-one correspondence with the driving units 430, and each driving unit 430 is configured to drive its corresponding light-emitting unit 440 to emit light (as illustrated in FIG. 17, and only one driving unit 430 and one light-emitting unit 440 are illustrated in the figure). In some other embodiments, one driving unit 430 may also correspond to two or more light-emitting units 440, and the driving unit 430 synchronously sends a same driving signal to the two or more light-emitting units 440, thereby effectively saving the material cost of the driving circuit and the space occupied by the driving circuit.

The driving unit 430 may be any type of transistor, for example, a bipolar junction transistor (BJT), a field effect transistor (FET), or a thin film transistor (TFT). The light-emitting unit 440 may be a light-emitting device such as an organic light-emitting diode (OLED), a quantum dot light-emitting diode (QLED), and an inorganic light-emitting diode.

Exemplarily, in the embodiments, the driving unit 430 is a TFT including an active layer 431, a gate insulating layer 432, a gate layer 433 and a source/drain layer 434 (as illustrated in FIG. 17). The active layer 431 is provided on the base plate 100 and is covered by the interlayer insulating layer 200. The gate insulating layer 432 is provided in the interlayer insulating layer 200 and is located on the active layer 431. The gate layer 433 is provided in the interlayer insulating layer 200 and is located on the gate insulating layer 432. The source/drain layer 434 is provided on the interlayer insulating layer 200, and penetrates through the interlayer insulating layer 200 to reach a level of the gate insulating layer 432, and the source/drain layer 434 is covered by the planarization layer 410. The gate insulating layer 432 is configured to insulate the source/drain layer 434 from the gate layer 433, to prevent a short circuit from being generated due to contact of the two electrode layers. Each layer of the driving unit 430 is made of a conventional material, which is not limited herein.

Exemplarily, in the embodiments, the light-emitting unit 440 is an OLED, including an anode 441, a hole function layer 442, a light-emitting layer 443, and an electron function layer/cathode 444 (as illustrated in FIG. 17) stacked in sequence. The anode 441 is provided on the planarization layer 410 and is connected, through a through hole of the planarization layer 410, with the source/drain layer 434 of the driving unit 430. The hole function layer 442 is provided on the anode 441 and covers the pixel defining layer 420, and is configured to control transmission of holes, so as to control recombination of the holes with electrons in the light-emitting layer, thereby improving the light-emitting efficiency. The light-emitting layer 443 is provided on the hole function layer 442. The light-emitting layer 443 at least includes a light-emitting material layer, where the light-emitting material includes an organic light-emitting material, and it may be provided with a light-emitting material emitting light at a proper wavelength based on the display requirements. The electron function layer/cathode 444 is provided on the light-emitting layer 443, and the electron function layer controls the transmission of electrons, so as to control the recombination of the electrons with the holes in the light-emitting layer, thereby improving the light-emitting efficiency. Each layer of the light-emitting unit 440 is made of a conventional material, which is not limited herein.

In the claimed invention, the package structure 500 is provided on the light-emitting array structure 400, and covers the light-emitting array structure 400 and the fourth grooves 100b, so as to effectively prevent the internal structure of the display panel from being eroded by water and oxygen, thereby improving the service life and reliability of the display panel. In the embodiments, through the provision of the fourth grooves 100b, the area of the exposed portion of the encapsulation area 122 of the base plate 100 may be increased, which increases the effective contact area between the encapsulation structure 500 and the base plate 100. In addition, the groove structures of the fourth grooves 100b themselves have a function of blocking water and oxygen. As such, the encapsulation structure 500 can effectively prevent the internal structure of the display panel from being eroded by water and oxygen, which effectively prolongs the service life of the display panel; meanwhile, it enables the occupied area in the horizontal plane of the non-display area 12 that is occupied by the encapsulation area 122 to be reduced, so as to narrow the non-display area 12. The width of the encapsulation region 122 is expected to be reduced, from the existing range between 300 µm to 400 µm, to be less than 150 µm.

It may be understood that the encapsulation structure 500 may be a structure of one or more layers, and it may be an organic film or an inorganic film, or may be a laminated structure of an organic film and an inorganic film.

For example, as illustrated in FIG. 17, the encapsulation structure 500 includes two inorganic encapsulation layers (which are a first inorganic encapsulation layer 510 and a second inorganic encapsulation layer 530, where the first inorganic encapsulation layer is close to the base plate 100 side and covers the fourth grooves 100b) and an organic encapsulation layer 520 provided between the two adjacent inorganic encapsulation layers. By covering the fourth grooves 100b with the first inorganic encapsulation layer 510, the encapsulation structure 500 may effectively prevent the internal structure of the display panel from being eroded by water and oxygen, which effectively improves the service life of the display panel; in addition, the occupied area in the horizontal plane of the non-display area 12 that is occupied by the encapsulation area 122 is reduced, so as to narrow the non-display area 12.

An orthographic projection of the first inorganic encapsulation layer 510 on the base plate 100 coincides with an orthographic projection of the second inorganic encapsulation layer 530 on the base plate 100, and an orthographic projection of the organic encapsulation layer 520 on the base plate 100 is located within the orthographic projection of the second inorganic encapsulation layer 530 on the base plate 100. The inorganic encapsulation layer has a good property of blocking the water and oxygen, but it has a large stress. The organic encapsulation layer has good toughness, which enables a good buffering force to be provided, but the organic encapsulation layer has a poor property of blocking the water and oxygen. Therefore, the inorganic encapsulation layer is required to isolate the organic encapsulation layer from air. The first inorganic encapsulation layer 510 and the second inorganic encapsulation layer 530 may be a dense inorganic films such as a SiN, SiO, Al2O3, or SiON film, and the organic encapsulation layer 520 may be an organic film such as an epoxy resin, polyurethane, or silicon-based film.

The display panel provided in the embodiment includes a base plate 100, an interlayer insulation layer 200, a wiring 300, a light-emitting array structure 400 and an encapsulation structure 500. The base plate 100 is provided with a plurality of first grooves 100a located in the wiring area 121 and a plurality of fourth grooves 100b located in the encapsulation area 122. The interlayer insulation layer 200 is provided on the base plate 100 and covers the first grooves 100a, and the interlayer insulation layer 200 is provided with a plurality of second grooves 200a at positions corresponding to the first grooves 100a. The wiring 300 is provided in the wiring area 121 of the interlayer insulation layer 200 and fills the second grooves 200a. The light-emitting array structure 400 is provided on the interlayer insulation layer 200 and the wiring 300, and the light-emitting array structure 400 is partially embedded in the interlayer insulation layer 200. The encapsulation structure 500 is provided on the light-emitting array structure 400, and covers the light-emitting array structure 400 and the fourth grooves 100b. By means of the first grooves 100a and the second grooves 200a, the effective contact area between the wiring 300 and the interlayer insulating layer 200 can be increased, and the surface resistance of the wiring area 121 can be reduced; on this basis, the size of the wiring area 121 can be reduced, and the area occupied by the wiring 300 on the display screen can be reduced. Through the provision of the fourth grooves 100b, the encapsulation structure 500 can more effectively prevent the display panel from being corroded by water and oxygen, which prolongs the service life of the display panel; in addition, the occupied area in the horizontal plane of the non-display area 12 that is occupied by the encapsulation area 122 can be reduced. In this way, both the wiring area 121 and the encapsulation area 122 are reduced, the size of the non-display area 12 can be effectively reduced, and the area actually used for display is effectively enlarged; thus, the screen-to-body ratio of the display screen is improved, and the display effect is improved.

It may be noted that the display panel is not limited to the above laminated structure, and various layers may be added with a material with special functions based on different requirements. For example, other functional materials are added to a film of a single function to obtain a film of multiple functions. In addition, the stacking sequence of the various films in the display panel may be changed based on the required functions, and other functional films may be added as required.

As illustrated in FIG. 18, FIG. 18 is a flowchart of a preparation method for a display panel according to an embodiment. For introduction to the structure of the display panel, reference may be made to the related description of the above embodiments, which is not repeated herein. The preparation method includes blocks 102 to 106.

At block 102, a base plate is provided, and a plurality of first grooves are provided. At block 104, an interlayer insulating layer is formed on the base plate, in such a manner that the interlayer insulating layer covers the first grooves and a plurality of second grooves located at positions corresponding to the first grooves are obtained in the interlayer insulating layer. The interlayer insulating layer may be formed by conventional processes and methods in the art, and details there are not described herein.

At block 106, a wiring is formed on a part of the interlayer insulating layer located in the non-display area, where the wiring fills the second grooves. The wiring may be formed by using conventional processes and methods in the art, and details there are not described herein.

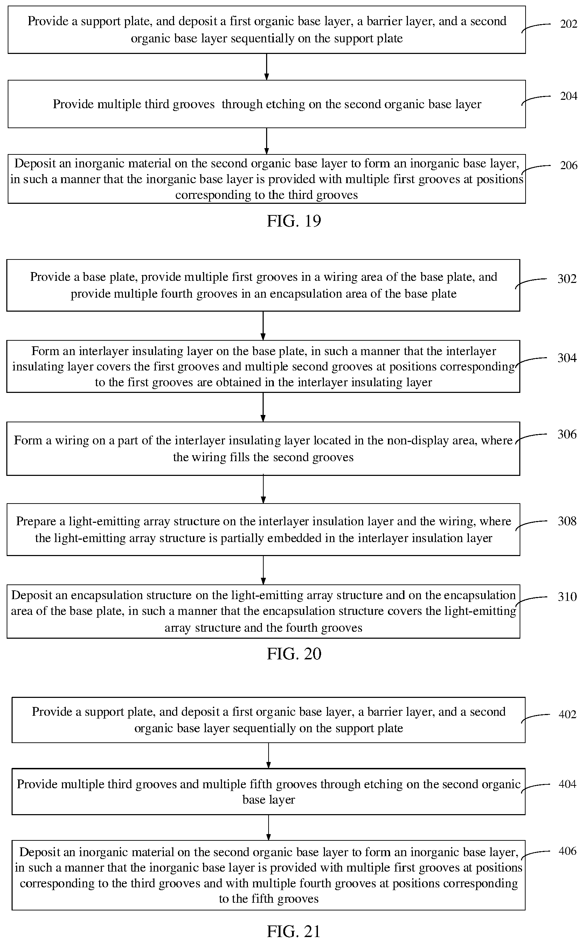

In some embodiments, as illustrated in FIG. 19, block 102 includes blocks 202 to 206.

At block 202, a support plate is provided, and a first organic base layer, a barrier layer, and a second organic base layer are sequentially deposited on the support plate. Exemplarily, the first organic base layer and the second organic base layer are deposited by a polyimide coating process, and the barrier layer is formed by a chemical vapor deposition (CVD) process. At block 204, a plurality of third grooves are provided through etching on the second organic base layer. At block 206, an inorganic material is deposited on the second organic base layer to form an inorganic base layer, in such a manner that the inorganic base layer is provided with the plurality of first grooves at positions corresponding to the third grooves. Exemplarily, the inorganic base layer is formed by the CVD process.

In the method provided in the embodiments, through the provision of the first grooves and the second grooves, the effective contact area between the wiring and the interlayer insulation layer can be increased, and the surface resistance of the wiring area can be reduced. On this basis, the size of the wiring area can be reduced, the area occupied by the wiring on the display screen is reduced, and the size of the non-display area can be effectively reduced. Thus, the area actually used for display is effectively enlarged, the screen-to-body ratio of the display screen is improved, and the display effect is improved.

FIG. 16, FIG. 20 is a flowchart of a preparation method for a display panel according to the claimed invention. The preparation method includes blocks 302 to 306.

At block 302, a base plate is provided, a plurality of first grooves are provided in a wiring area of the base plate, and a plurality of fourth grooves are provided in an encapsulation area of the base plate.

At block 304, an interlayer insulating layer is formed on the base plate, in such a manner that the interlayer insulating layer covers the first grooves and a plurality of second grooves at positions corresponding to the first grooves are obtained in the interlayer insulating layer.

At block 306, a wiring is formed on a part of the interlayer insulating layer located in the non-display area, where the wiring fills the second grooves.

At block 308, a light-emitting array structure is prepared on the interlayer insulation layer and the wiring, where the light-emitting array structure is partially embedded in the interlayer insulation layer.

At block 310, an encapsulation structure is deposited on the light-emitting array structure and on the encapsulation area of the base plate, in such a manner that the encapsulation structure covers the light-emitting array structure and the fourth grooves.

Blocks 304 and 306 may be performed with conventional processes and methods in the art, and details thereof are not described herein.

In some embodiments, as illustrated in FIG. 21, block 302 includes blocks 402 to 406.

At block 402, a support plate is provided, and a first organic base layer, a barrier layer, and a second organic base layer are sequentially deposited on the support plate. Exemplarily, the first organic base layer and the second organic base layer are deposited by a polyimide coating process, and the barrier layer is formed by the CVD process. At block 404, a plurality of third grooves and a plurality of fifth grooves are provided through etching on the second organic base layer. At block 406, an inorganic material is deposited on the second organic base layer to form an inorganic base layer, in such a manner that the inorganic base layer is provided with the plurality of first grooves at positions corresponding to the third grooves and with the plurality of fourth grooves at positions corresponding to the fifth grooves.

In some embodiments, block 308 includes: a driving unit is prepared in the display area of the interlayer insulating layer, a planarization layer is formed on the interlayer insulating layer, the wiring and the driving unit, and a light-emitting unit is prepared on the planarization layer.

Exemplarily, the process of forming the driving unit may include sequentially forming an active layer, a gate insulating layer, a gate layer and a source/drain layer, and the driving unit may be formed by using conventional processes and methods in the art, and details thereof are not described herein.

Exemplarily, the process of forming the light-emitting unit may include sequentially forming an anode, a hole function layer, a light-emitting layer, and an electron function layer/cathode. The driving unit and light-emitting unit may be formed by using conventional processes and methods in the art, and details thereof are not described herein.

In some embodiments, block 310 includes:
sequentially depositing, on the light-emitting array structure and an encapsulation area of the base plate, a first inorganic encapsulation layer, an inorganic encapsulation layer, and a second inorganic encapsulation layer, in such a manner that the first inorganic encapsulation layer covers the light-emitting array structure and the fourth grooves. The operations of forming the first inorganic encapsulation layer, the inorganic encapsulation layer and the second inorganic encapsulation layer may adopt conventional processes and methods in the art, and details thereof are not described herein.

In the method provided in the embodiments, through the provision of the first grooves and the second grooves, the effective contact area between the wiring and the interlayer insulation layer can be increased, and the surface resistance of the wiring area can be reduced. On this basis, the size of the wiring area can be reduced, and the area occupied by the wiring on the display screen is reduced. Through the provision of the fourth grooves, the encapsulation structure can more effectively prevent the internal structure of the display panel from being corroded by water and oxygen, which prolongs the service life of the display panel; and the occupied area in the horizontal plane of the non-display area that is caused by the encapsulation area can be reduced. In this way, both the wiring area and the encapsulation area are reduced, and the size of the non-display area can be effectively reduced; thus, the area actually used for display is effectively enlarged, the screen-to-body ratio of the display screen is improved, and the display effect is improved.

The present disclosure further provides an electronic device, which includes the display panel in the above embodiments or a display panel prepared by the method in the above embodiments. The electronic device provides a high screen-to-body ratio and a good display effect.

It may be noted that the division of individual units in the electronic device is only used for illustration, and in other embodiments, the electronic device may be divided into different modules as required to complete all or part of the functions of the electronic device.

The technical features of the foregoing embodiments may be combined arbitrarily, and all possible combinations of the technical features in the foregoing embodiments are not described for concise. However, as long as there is no contradiction in the combination of these technical features, it should be considered as falling within the scope described in the specification.

The foregoing embodiments only illustrate several implementations of the present disclosure, and their descriptions are relatively specific and detailed, but they should not be construed as limiting the scope of the present disclosure. It is notable for those skilled in the art that, several variations and improvements may be made by those skilled in the art without departing from the concept of the present disclosure, and all of them should fall within the protection scope of the present disclosure. Accordingly, the protection scope of the present disclosure is subject to the appended claims.

## Claims

1. A display panel (10), comprising a display area (11) and a non-display area (12), and the display panel (10) comprising:
a base plate (100), wherein the base plate (100) is provided with a first groove (100a), and the first groove (100a) is located in the non-display area (12);
an interlayer insulating layer (200), wherein the interlayer insulating layer (200) is provided on the base plate (100) and covers the first groove (100a), and the interlayer insulating layer (200) is provided with a second groove (200a) at a position corresponding to the first groove (100a); and
a wiring (300), wherein the wiring (300) is provided on a part of the interlayer insulating layer (200) located in the non-display area (12), and fills the second groove (200a);
wherein the base plate (100) is provided with a plurality of wiring areas (121) in the non-display area (12), and the first groove (100a) is located in at least one of the plurality of wiring areas (121);
the base plate (100) further comprises an encapsulation area (122), the encapsulation area (122) is located on a side of the wiring areas (121) away from the display area (11);
the display panel (10) further comprises a light-emitting array structure (400), wherein the light-emitting array structure (400) is provided on the interlayer insulating layer (200) and the wiring (300), and the light-emitting array structure (400) is partially embedded in the interlayer insulating layer (200);
**characterized in that**,
the base plate (100) is further provided therein with a plurality of fourth grooves (100b), the plurality of fourth grooves (100b) are located in the encapsulation area (122), and
the display panel (10) further comprises an encapsulation structure (500), wherein the encapsulation structure (500) is provided on the light-emitting array structure (400), and covers the light-emitting array structure (400) and the fourth grooves (100b).

2. The display panel (10) of claim 1, wherein there are a plurality of first grooves (100a);
in each of the plurality of wiring areas (121), at least two of the plurality of first grooves (100a) are arranged in a first direction, and/or at least two of the plurality of first grooves (100a) are arranged in a second direction, the first direction intersecting with the second direction.

3. The display panel (10) of claim 2, wherein the non-display area (12) comprises a first area (12A) and a second area (12B) that are respectively provided on two opposite sides of the display area (11), the non-display area (12) further comprises a third area (12C) connecting the first area (12A) and the second area (12B), and the first direction is perpendicular to an alternating direction along which the first area (12A), the display area (11), and the second area (12B) take place by turn;
in the wiring area (121) located in the first area (12A) and the wiring area (121) located in the second area (12B), at least one of the first grooves (100a) extends along the first direction; and
in the wiring area (121) located in the third area (12C), at least one of the first grooves (100a) extends in the alternating direction.

4. The display panel (10) of claim 2, wherein the plurality of wiring areas (121) surround an edge of the display area (11), and each of the plurality of wiring areas (121) is provided with at least one of the first grooves (100a), the plurality of wiring areas (121) are symmetrically distributed with respect to an axis of symmetry, and the plurality of first grooves (100a) are symmetrically arranged with respect to the axis of symmetry; or
the plurality of wiring areas (121) are symmetrically distributed with respect to an axis of symmetry, and the plurality of first grooves (100a) are symmetrically distributed with respect to the axis of symmetry.

5. The display panel (10) of any one of claims 2-4, wherein each of the plurality of first grooves (100a) is selected from a strip-type groove, an annular groove or a hole-type groove; the plurality of first grooves (100a) are annular grooves surrounding the display area (11), and each of the plurality of first grooves (100a) is located in the plurality of the wiring areas (121).

6. The display panel (10) of any one of claims 1-5, wherein a longitudinal section of the first groove (100a) is in an open-top shape with an opening increasing gradually from a side away from the wiring (300) to a side close to the wiring (300), and the longitudinal section is a section perpendicular to a length direction of the first groove (100a).

7. The display panel (10) of any one of claims 2-6, wherein the base plate (100) comprises:
a flexible substrate (110), wherein the flexible substrate (110) is provided with a plurality of third grooves (110a), and the plurality of third grooves (110a) are located in the non-display area (12); and
an inorganic base layer (120) provided on the flexible substrate (110), wherein the plurality of first grooves (100a) are provided in the inorganic base layer (120) at positions corresponding to the plurality of third grooves (110a),
wherein the flexible substrate (110) comprises a support plate (111), and the flexible substrate (110) further comprises a first organic base layer (112), a barrier layer (113) and a second organic base layer (114) sequentially provided on the support plate (111), wherein the plurality of third grooves (110a) are provided in the second organic base layer (114).

8. The display panel (10) of claim 3, wherein
a cross section of each of the first grooves (100a) is in a circular shape, any two circular grooves adjacent in the first direction are arranged side by side and aligned, and any two circular grooves adjacent in the second direction are staggered with each other;
or
a cross section of each of the first grooves (100a) is in a rectangular shape, any two rectangular grooves adjacent in the first direction are arranged side by side and aligned, and any two rectangular grooves adjacent in the second direction are staggered with each other;
or
a cross section of each of the first grooves (100a) is in a rectangular shape, any two rectangular grooves adjacent in the first direction are arranged side by side and aligned, and any two rectangular grooves adjacent in the second direction are arranged side by side and aligned.

9. The display panel (10) of claim 1, wherein there are a plurality of encapsulation areas (122); in each of the encapsulation areas (122), at least two of the plurality of fourth grooves (100b) are arranged in a third direction, and/or at least two of the plurality of fourth grooves (100b) are arranged in a fourth direction, the third direction intersecting with the fourth direction.

10. The display panel (10) of claim 1, wherein the base plate (100) is provided with a plurality of encapsulation areas (122), and the fourth grooves (100b) are located in at least one of the plurality of encapsulation areas (122).

11. The display panel (10) of claim 9, wherein the non-display area (12) comprises a first area (12A) and a second area (12B) that are respectively provided on two opposite sides of the display area (11), the non-display area (12) further comprises a third area (12C) connecting the first area (12A) and the second area (12B), and the third direction is perpendicular to an alternating direction along which the first area (12A), the display area (11), and the second area (12B) take place by turn; in the encapsulation area (122) located in the first area (12A) and the encapsulation area (122) located in the second area (12B), at least one of the fourth grooves (100b) extends along the third direction; and in the encapsulation area (122) located in the third area (12C), at least one of the fourth grooves (100b) extends along the alternating direction; and
the fourth grooves (100b) are strip-type grooves, and a plurality of continuously extending strip-type grooves are provided in each of the encapsulation areas (122); or, the fourth grooves (100b) each are an annular groove provided around the display area (11), each of the fourth grooves (100b) is located in the plurality of encapsulation areas (122), and the plurality of fourth grooves (100b) define a plurality of continuous annular grooves.

12. The display panel (10) of any one of claims 1-11, wherein the light-emitting array structure (400) comprises:
a planarization layer (410), wherein the planarization layer (410) is provided on the interlayer insulating layer (200) and the wiring (300);
a pixel defining layer (420), wherein the pixel defining layer (420) is provided on the planarization layer (410);
a driving unit (430), wherein the driving unit (430) is provided in the interlayer insulating layer (200) and the planarization layer (410); and
a light-emitting unit (440), wherein the light-emitting unit (440) is provided at the pixel defining layer (420), and penetrates through the pixel defining layer (420) and a part of the planarization layer (410), the light-emitting unit (440) is electrically connected with the driving unit (430), and both the light-emitting unit (440) and the driving unit (430) are located in the display area (11).

13. The display panel (10) of claim 1, wherein a longitudinal section of each of the fourth grooves (100b) is a triangle shape, an inverted trapezoid shape, a semicircle shape or a semi-ellipse shape.

14. A preparation method for a display panel (10) of any one of claims 1-12, the display panel (10) comprising a display area (11) and a non-display area (12), and the method comprising:
providing a base plate (100), and providing a first groove (100a) in the non-display area (12) of the base plate (100);
forming an interlayer insulating layer (200) on the base plate (100), in such a manner that the interlayer insulating layer (200) covers the first groove (100a) and a second groove (200a) located at a position corresponding to the first groove (100a) is obtained in the interlayer insulating layer (200); and
forming a wiring (300) on a part of the interlayer insulating layer (200) located in the non-display area (12), wherein the wiring (300) fills the second groove (200a);
wherein the non-display area (12) comprises a wiring area (121) and an encapsulation area (122), the encapsulation area (122) is located on a side of the wiring area (121) away from the display area (11);
the providing a first groove (100a) in the non-display area (12) of the base plate (100) comprises: providing a plurality of first grooves (100a) in the wiring area (121) of the base plate (100),
the method is **characterized by** further comprising:
providing a plurality of fourth grooves (100b) in the encapsulation area (122) of the base plate (100);
after the forming of the wiring (300), preparing a light-emitting array structure (400) on the interlayer insulating layer (200) and the wiring (300), wherein the light-emitting array structure (400) is partially embedded in the interlayer insulating layer (200); and
depositing an encapsulation structure (500) on the light-emitting array structure (400) and on the encapsulation area (122) of the base plate (100), in such a manner that the encapsulation structure (500) covers the light-emitting array structure (400) and the plurality of fourth grooves (100b).

15. An electronic device, comprising the display panel (10) of any one of claims 1-13.

## Patentansprüche

1. Anzeigetafel (10), umfassend einen Anzeigebereich (11) und einen Nicht-Anzeigebereich (12), wobei die Anzeigetafel (10) umfasst:
eine Grundplatte (100), wobei die Grundplatte (100) mit einer ersten Nut (100a) bereitgestellt ist und sich die erste Nut (100a) im Nicht-Anzeigebereich (12) befindet;
eine Zwischenschicht-Isolierschicht (200), wobei die Zwischenschicht-Isolierschicht (200) auf der Grundplatte (100) bereitgestellt ist und die erste Nut (100a) abdeckt, und die Zwischenschicht-Isolierschicht (200) an einer der ersten Nut (100a) entsprechenden Position mit einer zweiten Nut (200a) bereitgestellt ist; und
eine Verdrahtung (300), wobei die Verdrahtung (300) auf einem Teil der Zwischenschicht-Isolierschicht (200) bereitgestellt ist, der sich im Nicht-Anzeigebereich (12) befindet, und die zweite Nut (200a) ausfüllt;
wobei die Grundplatte (100) im Nicht-Anzeigebereich (12) mit einer Vielzahl von Verdrahtungsbereichen (121) bereitgestellt ist und sich die erste Nut (100a) in mindestens einem der Vielzahl von Verdrahtungsbereichen (121) befindet;
die Grundplatte (100) weiter einen Verkapselungsbereich (122) umfasst, wobei sich der Verkapselungsbereich (122) auf einer Seite der Verdrahtungsbereiche (121) entfernt vom Anzeigebereich (11) befindet;
die Anzeigetafel (10) weiter eine Lichtemissionsanordnungsstruktur (400) umfasst, wobei die Lichtemissionsanordnungsstruktur (400) auf der Zwischenschicht-Isolierschicht (200) und der Verdrahtung (300) bereitgestellt ist und die Licht emittierende Array-Struktur (400) teilweise in die Zwischenschicht-Isolierschicht (200) eingebettet ist;
**dadurch gekennzeichnet, dass**
die Grundplatte (100) weiter mit einer Vielzahl von vierten Nuten (100b) bereitgestellt ist, wobei sich die Vielzahl von vierten Nuten (100b) im Verkapselungsbereich (122) befindet, und
die Anzeigetafel (10) weiter eine Verkapselungsstruktur (500) umfasst, wobei die Verkapselungsstruktur (500) auf der Lichtemissionsanordnungsstruktur (400) bereitgestellt ist und die Lichtemissionsanordnungsstruktur (400) und die vierten Nuten (100b) abdeckt.

2. Anzeigetafel (10) nach Anspruch 1, wobei eine Vielzahl von ersten Nuten (100a) vorhanden ist;
in jedem der Vielzahl von Verdrahtungsbereichen (121) mindestens zwei der Vielzahl von ersten Nuten (100a) in einer ersten Richtung angeordnet sind und/oder mindestens zwei der Vielzahl von ersten Nuten (100a) in einer zweiten Richtung angeordnet sind, wobei sich die erste Richtung mit der zweiten Richtung schneidet.

3. Anzeigetafel (10) nach Anspruch 2, wobei der Nicht-Anzeigebereich (12) einen ersten Bereich (12A) und einen zweiten Bereich (12B) umfasst, die jeweils an zwei gegenüberliegenden Seiten des Anzeigebereichs (11) bereitgestellt sind, der Nicht-Anzeigebereich (12) weiter einen dritten Bereich (12C) umfasst, der den ersten Bereich (12A) und den zweiten Bereich (12B) verbindet, und die erste Richtung senkrecht zu einer Wechselrichtung steht, entlang derer der erste Bereich (12A), der Anzeigebereich (11) und der zweite Bereich (12B) abwechselnd verlaufen;
sich im Verdrahtungsbereich (121), der sich im ersten Bereich (12A) befindet, und im Verdrahtungsbereich (121), der sich im zweiten Bereich (12B) befindet, mindestens eine der ersten Nuten (100a) entlang der ersten Richtung erstreckt; und
sich im Verdrahtungsbereich (121), der sich im dritten Bereich (12C) befindet, mindestens eine der ersten Nuten (100a) in der Wechselrichtung erstreckt.

4. Anzeigetafel (10) nach Anspruch 2, wobei die Vielzahl von Verdrahtungsbereichen (121) einen Rand des Anzeigebereichs (11) umgibt, und jeder der Vielzahl von Verdrahtungsbereichen (121) mit mindestens einer der ersten Nuten (100a) bereitgestellt ist, die Vielzahl von Verdrahtungsbereichen (121) symmetrisch in Bezug auf eine Symmetrieachse verteilt ist und die Vielzahl von ersten Nuten (100a) symmetrisch in Bezug auf die Symmetrieachse angeordnet ist; oder
die Vielzahl von Verdrahtungsbereichen (121) symmetrisch in Bezug auf eine Symmetrieachse verteilt ist und die Vielzahl von ersten Nuten (100a) symmetrisch in Bezug auf die Symmetrieachse verteilt ist.

5. Anzeigetafel (10) nach einem der Ansprüche 2-4, wobei jede der Vielzahl von ersten Nuten (100a) aus einer schiffsförmigen Nut, einer ringförmigen Nut oder einer lochförmigen Nut ausgewählt ist; die Vielzahl von ersten Nuten (100a) ringförmige Nuten sind, die den Anzeigebereich (11) umgeben, und jede der Vielzahl von ersten Nuten (100a) sich in der Vielzahl von Verdrahtungsbereichen (121) befindet.

6. Anzeigetafel (10) nach einem der Ansprüche 1-5, wobei ein Längsschnitt der ersten Nut (100a) eine oben offene Form aufweist, wobei sich die Öffnung von einer von der Verdrahtung (300) entfernten Seite zu einer der Verdrahtung (300) nahen Seite hin allmählich vergrößert, und wobei der Längsschnitt ein Schnitt senkrecht zur Längsrichtung der ersten Nut (100a) ist.

7. Anzeigetafel (10) nach einem der Ansprüche 2-6, wobei die Grundplatte (100) umfasst:
ein flexibles Substrat (110), wobei das flexible Substrat (110) mit einer Vielzahl von dritten Nuten (110a) bereitgestellt ist und sich die Vielzahl von dritten Nuten (110a) im Nicht-Anzeigebereich (12) befindet; und
eine anorganische Basisschicht (120), die auf dem flexiblen Substrat (110) bereitgestellt ist, wobei die Vielzahl von ersten Nuten (100a) in der anorganischen Basisschicht (120) an Positionen bereitgestellt sind, die der Vielzahl von dritten Nuten (110a) entsprechen,
wobei das flexible Substrat (110) eine Trägerplatte (111) umfasst, und das flexible Substrat (110) weiter eine erste organische Basisschicht (112), eine Barriereschicht (113) und eine zweite organische Basisschicht (114) umfasst, die nacheinander auf der Trägerplatte (111) bereitgestellt sind, wobei die Vielzahl an dritten Rillen (110a) in der zweiten organischen Basisschicht (114) bereitgestellt sind.

8. Anzeigetafel (10) nach Anspruch 3, wobei
ein Querschnitt jeder der ersten Nuten (100a) kreisförmig ist, zwei beliebige in der ersten Richtung benachbarte kreisförmige Nuten nebeneinander angeordnet und miteinander ausgerichtet sind und zwei beliebige in der zweiten Richtung benachbarte kreisförmige Nuten versetzt zueinander angeordnet sind;
oder
ein Querschnitt jeder der ersten Nuten (100a) rechteckig ist, zwei beliebige in der ersten Richtung benachbarte rechteckige Nuten nebeneinander angeordnet und miteinander ausgerichtet sind und zwei beliebige in der zweiten Richtung angrenzende rechteckige Nuten versetzt zueinander angeordnet sind;
oder
ein Querschnitt jeder der ersten Nuten (100a) rechteckig ist, zwei beliebige in der ersten Richtung benachbarte rechteckige Nuten nebeneinander angeordnet und miteinander ausgerichtet sind und zwei beliebige in der zweiten Richtung angrenzende rechteckige Nuten nebeneinander angeordnet und miteinander ausgerichtet sind.

9. Anzeigetafel (10) nach Anspruch 1, wobei dort eine Vielzahl von Verkapselungsbereichen (122) vorhanden ist; in jedem der Verkapselungsbereiche (122) mindestens zwei der Vielzahl von vierten Nuten (100b) in einer dritten Richtung und/oder mindestens zwei der Vielzahl von vierten Nuten (100b) in einer vierten Richtung angeordnet sind, wobei die dritte Richtung die vierte Richtung schneidet.

10. Anzeigetafel (10) nach Anspruch 1, wobei die Grundplatte (100) mit einer Vielzahl von Verkapselungsbereichen (122) bereitgestellt ist und sich die vierten Nuten (100b) in mindestens einem der vielen Verkapselungsbereiche (122) befinden.

11. Anzeigetafel (10) nach Anspruch 9, wobei der Nicht-Anzeigebereich (12) einen ersten Bereich (12A) und einen zweiten Bereich (12B) umfasst, die jeweils an zwei gegenüberliegenden Seiten des Anzeigebereichs (11) bereitgestellt sind, der Nicht-Anzeigebereich (12) weiter einen dritten Bereich (12C) umfasst, der den ersten Bereich (12A) und den zweiten Bereich (12B) verbindet, und die dritte Richtung senkrecht zu einer Wechselrichtung ist, entlang derer der erste Bereich (12A), der Anzeigebereich (11) und der zweite Bereich (12B) abwechselnd verlaufen; im Verkapselungsbereich (122), der sich im ersten Bereich (12A) befindet, und im Verkapselungsbereich (122), der sich im zweiten Bereich (12B) befindet, sich mindestens eine der vierten Nuten (100b) entlang der dritten Richtung erstreckt; und in dem im dritten Bereich (12C) befindlichen Verkapselungsbereich (122) sich mindestens eine der vierten Nuten (100b) entlang der abwechselnden Richtung erstreckt; und
die vierten Nuten (100b) streifenförmige Nuten sind und eine Vielzahl von sich kontinuierlich erstreckenden streifenförmigen Nuten in jedem der Verkapselungsbereiche (122) bereitgestellt sind; oder die vierten Nuten (100b) jeweils eine ringförmige Nut sind, die um den Anzeigebereich (11) herum bereitgestellt ist, wobei sich jede der vierten Nuten (100b) in einem der Vielzahl von Verkapselungsbereichen (122) befindet und die Vielzahl von vierten Nuten (100b) eine Vielzahl von durchgehenden ringförmigen Nuten definiert.

12. Anzeigetafel (10) nach einem der Ansprüche 1 bis 11, wobei die Lichtemissionsanordnungsstruktur (400) umfasst:
eine Planarisierungsschicht (410), wobei die Planarisierungsschicht (410) auf der Zwischenschicht-Isolierschicht (200) und der Verdrahtung (300) bereitgestellt ist;
eine Pixeldefinitionsschicht (420), wobei die Pixeldefinitionsschicht (420) auf der Planarisierungsschicht (410) bereitgestellt ist;
eine Antriebseinheit (430), wobei die Antriebseinheit (430) in der Zwischenschicht-Isolierschicht (200) und der Planarisierungsschicht (410) bereitgestellt ist; und
eine Lichtemissionseinheit (440), wobei die Lichtemissionseinheit (440) an der Pixeldefinitionsschicht (420) bereitgestellt ist und die Pixeldefinitionsschicht (420) und einen Teil der Planarisierungsschicht (410) durchdringt, wobei die Lichtemissionseinheit (440) elektrisch mit der Antriebseinheit (430) verbunden ist, und sowohl die Lichtemissionseinheit (440) als auch die Antriebseinheit (430) sich im Anzeigebereich (11) befinden.

13. Anzeigetafel (10) nach Anspruch 1, wobei ein Längsschnitt jeder der vierten Nuten (100b) eine Dreiecksform, eine umgekehrte Trapezform, eine Halbkreisform oder eine Halbellipsenform aufweist.

14. Verfahren zur Herstellung einer Anzeigetafel (10) nach einem der Ansprüche 1-12, wobei die Anzeigetafel (10) einen Anzeigebereich (11) und einen Nicht-Anzeigebereich (12) umfasst und das Verfahren umfasst:
Bereitstellen einer Grundplatte (100) und Bereitstellen einer ersten Nut (100a) im Nicht-Anzeigebereich (12) der Grundplatte (100);
Bilden einer Zwischenschicht-Isolierschicht (200) auf der Grundplatte (100) derart, dass die Zwischenschicht-Isolierschicht (200) die erste Nut (100a) bedeckt und eine zweite Nut (200a), die sich an einer der ersten Nut (100a) entsprechenden Position befindet, in der Zwischenschicht-Isolierschicht (200) erhalten wird; und
Bilden einer Verdrahtung (300) auf einem Teil der Zwischenschicht-Isolierschicht (200), der sich im Nicht-Anzeigebereich (12) befindet, wobei die Verdrahtung (300) die zweite Nut (200a) ausfüllt;
wobei der Nicht-Anzeigebereich (12) einen Verdrahtungsbereich (121) und einen Verkapselungsbereich (122) umfasst, wobei sich der Verkapselungsbereich (122) auf einer vom Anzeigebereich (11) entfernten Seite des Verdrahtungsbereichs (121) befindet;
das Bereitstellen einer ersten Nut (100a) im Nicht-Anzeigebereich (12) der Grundplatte (100) umfasst: Bereitstellen einer Vielzahl von ersten Nuten (100a) im Verdrahtungsbereich (121) der Grundplatte (100),
das Verfahren **dadurch gekennzeichnet ist, dass** es weiter umfasst:
Bereitstellen einer Vielzahl von vierten Nuten (100b) im Verkapselungsbereich (122) der Grundplatte (100);
nach dem Bilden der Verdrahtung (300), Herstellen einer Lichtemissionsanordnungsstruktur (400) auf der Zwischenschicht-Isolierschicht (200) und der Verdrahtung (300), wobei die Lichtemissionsanordnungsstruktur (400) teilweise in die Zwischenschicht-Isolierschicht (200) eingebettet ist; und
Aufbringen einer Verkapselungsstruktur (500) auf die Lichtemissionsanordnungsstruktur (400) und auf den Verkapselungsbereich (122) der Grundplatte (100) derart, dass die Verkapselungsstruktur (500) die Lichtemissionsanordnungsstruktur (400) und die Vielzahl von vierten Nuten (100b) bedeckt.

15. Elektronische Vorrichtung, umfassend die Anzeigetafel (10) nach einem der Ansprüche 1-13.

## Revendications

1. Panneau d'affichage (10), comprenant une zone d'affichage (11) et une zone de non-affichage (12), et le panneau d'affichage (10) comprenant :
une plaque de base (100), dans lequel la plaque de base (100) est munie d'une première rainure (100a), et la première rainure (100a) est située dans la zone de non-affichage (12) ;
une couche isolante intermédiaire (200), dans lequel la couche isolante intermédiaire (200) est fournie sur la plaque de base (100) et couvre la première rainure (100a), et la couche isolante intermédiaire (200) est munie d'une deuxième rainure (200a) à une position correspondant à la première rainure (100a) ; et
un câblage (300), dans lequel le câblage (300) est fourni sur une partie de la couche isolante intermédiaire (200) située dans la zone de non-affichage (12), et remplit la deuxième rainure (200a) ;
dans lequel la plaque de base (100) est munie d'une pluralité de zones de câblage (121) dans la zone de non-affichage (12), et la première rainure (100a) est située dans au moins une de la pluralité de zones de câblage (121) ;
la plaque de base (100) comprend en outre une zone d'encapsulation (122), la zone d'encapsulation (122) est située sur un côté des zones de câblage (121) éloigné de la zone d'affichage (11) ;
le panneau d'affichage (10) comprend en outre une structure de réseau électroluminescent (400), dans lequel la structure de réseau électroluminescent (400) est fournie sur la couche isolante intermédiaire (200) et le câblage (300), et la structure de réseau électroluminescent (400) est partiellement intégrée dans la couche isolante intermédiaire (200) ;
**caractérisé en ce que**,
la plaque de base (100) est en outre munie d'une pluralité de quatrièmes rainures (100b), la pluralité de quatrièmes rainures (100b) sont situées dans la zone d'encapsulation (122), et
le panneau d'affichage (10) comprend en outre une structure d'encapsulation (500), dans lequel la structure d'encapsulation (500) est fournie sur la structure de réseau électroluminescent (400) et couvre la structure de réseau électroluminescent (400) et les quatrièmes rainures (100b).

2. Panneau d'affichage (10) selon la revendication 1, dans lequel il y a une pluralité de premières rainures (100a) ;
dans chacune de la pluralité de zones de câblage (121), au moins deux de la pluralité de premières rainures (100a) sont agencées dans une première direction, et/ou au moins deux de la pluralité de premières rainures (100a) sont agencées dans une deuxième direction, la première direction croisant la deuxième direction.

3. Panneau d'affichage (10) selon la revendication 2, dans lequel la zone de non-affichage (12) comprend une première zone (12A) et une deuxième zone (12B) qui sont respectivement fournies sur deux côtés opposés de la zone d'affichage (11), la zone de non-affichage (12) comprend en outre une troisième zone (12C) reliant la première zone (12A) et la deuxième zone (12B), et la première direction est perpendiculaire à une direction d'alternance le long de laquelle la première zone (12A), la zone d'affichage (11) et la deuxième zone (12B) se succèdent ;
dans la zone de câblage (121) située dans la première zone (12A) et la zone de câblage (121) située dans la deuxième zone (12B), au moins une des premières rainures (100a) s'étend le long de la première direction ; et
dans la zone de câblage (121) située dans la troisième zone (12C), au moins une des premières rainures (100a) s'étend dans la direction d'alternance.

4. Panneau d'affichage (10) selon la revendication 2, dans lequel la pluralité de zones de câblage (121) entoure un bord de la zone d'affichage (11), et chacune de la pluralité de zones de câblage (121) est munie d'au moins une des premières rainures (100a), la pluralité de zones de câblage (121) sont réparties symétriquement par rapport à un axe de symétrie, et la pluralité de premières rainures (100a) sont agencées symétriquement par rapport à l'axe de symétrie ; ou
la pluralité de zones de câblage (121) sont réparties symétriquement par rapport à un axe de symétrie, et la pluralité de premières rainures (100a) sont réparties symétriquement par rapport à l'axe de symétrie.

5. Panneau d'affichage (10) selon l'une quelconque des revendications 2-4, dans lequel chacune de la pluralité de premières rainures (100a) est sélectionnée parmi une rainure de type bande, une rainure annulaire ou une rainure de type trou ; la pluralité de premières rainures (100a) sont des rainures annulaires entourant la zone d'affichage (11), et chacune de la pluralité de premières rainures (100a) est située dans la pluralité de zones de câblage (121).

6. Panneau d'affichage (10) selon l'une quelconque des revendications 1-5, dans lequel une section longitudinale de la première rainure (100a) est de forme ouverte sur le dessus avec une ouverture augmentant progressivement d'un côté éloigné du câblage (300) à un côté proche du câblage (300), et la section longitudinale est une section perpendiculaire à une direction de longueur de la première rainure (100a).

7. Panneau d'affichage (10) selon l'une quelconque des revendications 2-6, dans lequel la plaque de base (100) comprend :
un substrat flexible (110), dans lequel le substrat flexible (110) est muni d'une pluralité de troisièmes rainures (110a), et la pluralité de troisièmes rainures (110a) sont situées dans la zone de non-affichage (12) ; et
une couche de base inorganique (120) fournie sur le substrat flexible (110), dans lequel la pluralité de premières rainures (100a) sont fournies dans la couche de base inorganique (120) à des positions correspondant à la pluralité de troisièmes rainures (110a),
dans lequel le substrat flexible (110) comprend une plaque de support (111), et le substrat flexible (110) comprend en outre une première couche de base organique (112), une couche barrière (113) et une seconde couche de base organique (114) fournies séquentiellement sur la plaque de support (111), dans lequel la pluralité de troisièmes rainures (110a) sont fournies dans la seconde couche de base organique (114).

8. Panneau d'affichage (10) selon la revendication 3, dans lequel
une section transversale de chacune des premières rainures (100a) est de forme circulaire, deux rainures circulaires adjacentes dans la première direction sont agencées côte à côte et alignées, et deux rainures circulaires adjacentes dans la deuxième direction sont décalées l'une par rapport à l'autre ;
ou
une section transversale de chacune des premières rainures (100a) est de forme rectangulaire, deux rainures rectangulaires adjacentes dans la première direction sont agencées côte à côte et alignées, et deux rainures rectangulaires adjacentes dans la deuxième direction sont décalées l'une par rapport à l'autre ;
ou
une section transversale de chacune des premières rainures (100a) est de forme rectangulaire, deux rainures rectangulaires adjacentes dans la première direction sont agencées côte à côte et alignées, et deux rainures rectangulaires adjacentes dans la deuxième direction sont agencées côte à côte et alignées.

9. Panneau d'affichage (10) selon la revendication 1, dans lequel il y a une pluralité de zones d'encapsulation (122) ; dans chacune des zones d'encapsulation (122), au moins deux de la pluralité de quatrièmes rainures (100b) sont agencées dans une troisième direction, et/ou au moins deux de la pluralité de quatrièmes rainures (100b) sont agencées dans une quatrième direction, la troisième direction croisant la quatrième direction.

10. Panneau d'affichage (10) selon la revendication 1, dans lequel la plaque de base (100) est munie d'une pluralité de zones d'encapsulation (122), et les quatrièmes rainures (100b) sont situées dans au moins une de la pluralité de zones d'encapsulation (122).

11. Panneau d'affichage (10) selon la revendication 9, dans lequel la zone de non-affichage (12) comprend une première zone (12A) et une deuxième zone (12B) qui sont fournies respectivement sur deux côtés opposés de la zone d'affichage (11), la zone de non-affichage (12) comprend en outre une troisième zone (12C) reliant la première zone (12A) et la deuxième zone (12B), et la troisième direction est perpendiculaire à une direction d'alternance le long de laquelle la première zone (12A), la zone d'affichage (11) et la deuxième zone (12B) se succèdent ; dans la zone d'encapsulation (122) située dans la première zone (12A) et la zone d'encapsulation (122) située dans la deuxième zone (12B), au moins une des quatrièmes rainures (100b) s'étend le long de la troisième direction ; et dans la zone d'encapsulation (122) située dans la troisième zone (12C), au moins une des quatrièmes rainures (100b) s'étend le long de la direction d'alternance ; et
les quatrièmes rainures (100b) sont des rainures de type bande, et une pluralité de rainures de type bande s'étendant en continu sont fournies dans chacune des zones d'encapsulation (122) ; ou les quatrièmes rainures (100b) sont chacune une rainure annulaire fournie autour de la zone d'affichage (11), chacune des quatrièmes rainures (100b) est située dans la pluralité de zones d'encapsulation (122), et la pluralité de quatrièmes rainures (100b) définissent une pluralité de rainures annulaires continues.

12. Panneau d'affichage (10) selon l'une quelconque des revendications 1-11, dans lequel la structure de réseau électroluminescent (400) comprend :
une couche de planarisation (410), dans lequel la couche de planarisation (410) est fournie sur la couche isolante intermédiaire (200) et le câblage (300) ;
une couche de définition de pixels (420), dans lequel la couche de définition de pixels (420) est fournie sur la couche de planarisation (410) ;
une unité d'entraînement (430), dans lequel l'unité d'entraînement (430) est fournie dans la couche isolante intermédiaire (200) et la couche de planarisation (410) ; et
une unité électroluminescente (440), dans lequel l'unité électroluminescente (440) est fournie au niveau de la couche de définition de pixels (420) et pénètre à travers la couche de définition de pixels (420) et une partie de la couche de planarisation (410), l'unité électroluminescente (440) est connectée électriquement à l'unité d'entraînement (430), et l'unité électroluminescente (440) et l'unité d'entraînement (430) sont toutes deux situées dans la zone d'affichage (11).

13. Panneau d'affichage (10) selon la revendication 1, dans lequel une section longitudinale de chacune des quatrièmes rainures (100b) est de forme triangulaire, de forme trapézoïdale inversée, de forme semi-circulaire ou de forme semi-elliptique.

14. Procédé de préparation pour un panneau d'affichage (10) selon l'une quelconque des revendications 1-12, le panneau d'affichage (10) comprenant une zone d'affichage (11) et une zone de non-affichage (12), et le procédé comprenant :
la fourniture d'une plaque de base (100) et la fourniture d'une première rainure (100a) dans la zone de non-affichage (12) de la plaque de base (100) ;
la formation d'une couche isolante intermédiaire (200) sur la plaque de base (100), de telle sorte que la couche isolante intermédiaire (200) couvre la première rainure (100a) et qu'une deuxième rainure (200a) située à une position correspondant à la première rainure (100a) soit obtenue dans la couche isolante intermédiaire (200) ; et
la formation d'un câblage (300) sur une partie de la couche isolante intermédiaire (200) située dans la zone de non-affichage (12), dans lequel le câblage (300) remplit la deuxième rainure (200a) ;
dans lequel la zone de non-affichage (12) comprend une zone de câblage (121) et une zone d'encapsulation (122), la zone d'encapsulation (122) est située sur un côté de la zone de câblage (121) éloigné de la zone d'affichage (11) ;
la fourniture d'une première rainure (100a) dans la zone de non-affichage (12) de la plaque de base (100) comprend : la fourniture d'une pluralité de premières rainures (100a) dans la zone de câblage (121) de la plaque de base (100),
le procédé est **caractérisé en ce qu'**il comprend en outre :
la fourniture d'une pluralité de quatrièmes rainures (100b) dans la zone d'encapsulation (122) de la plaque de base (100) ;
après la formation du câblage (300), la préparation d'une structure de réseau électroluminescent (400) sur la couche isolante intermédiaire (200) et le câblage (300), dans lequel la structure de réseau électroluminescent (400) est partiellement intégrée dans la couche isolante intermédiaire (200) ; et
le dépôt d'une structure d'encapsulation (500) sur la structure de réseau électroluminescent (400) et sur la zone d'encapsulation (122) de la plaque de base (100), de telle sorte que la structure d'encapsulation (500) couvre la structure de réseau électroluminescent (400) et la pluralité de quatrièmes rainures (100b).

15. Dispositif électronique, comprenant le panneau d'affichage (10) selon l'une quelconque des revendications 1-13.
